(19) Europäisches Patentamt

European Patent Office

Office européen des brevets

(11) Veröffentlichungsnummer: **0 310 590 B1**

# (12) EUROPÄISCHE PATENTSCHRIFT

(45) Veröffentlichungstag der Patentschrift: **17.02.93**

(21) Anmeldenummer: **88890191.5**

(22) Anmeldetag: **20.07.88**

(51) Int. Cl.⁵: **C23F 1/08**, H01J 37/305, H01L 21/302, H01L 21/26, C23C 14/00

(54) **Behandlung mit Ionen von als Kathode geschalteten Innenflächen von Gegenständen.**

(30) Priorität: **01.09.87 AT 2192/87**

(43) Veröffentlichungstag der Anmeldung:
**05.04.89 Patentblatt 89/14**

(45) Bekanntmachung des Hinweises auf die Patenterteilung:
**17.02.93 Patentblatt 93/07**

(84) Benannte Vertragsstaaten:
**CH DE FR GB IT LI NL**

(56) Entgegenhaltungen:
**DD-A- 123 952**

**PATENT ABSTRACTS OF JAPAN, unexamined applications, C Field, Vol. 7, No. 122, 26. Mai 1983 THE PATENT OFFICE JAPANESE GOVERNMENT, Seite 5 C 168**

(73) Patentinhaber: **MIBA Gleitlager Aktiengesellschaft**
**Dr.-Mitterbauer-Strasse 3**
**A-4663 Laakirchen(AT)**

(72) Erfinder: **Gärtner, Walter, Dipl.-Ing.**
**Anton Schosserstrasse 27**
**A-4810 Gmunden(AT)**
Erfinder: **Koroschetz, Franz, Dr., Dipl.-Ing.**
**Rustonstrasse 5**
**A-4810 Gmunden(AT)**
Erfinder: **Wagendristel, Alfred, Dr., Dipl.-Ing.**
**Franz Veselygasse 9**
**A-2380 Perchtoldsdorf(AT)**
Erfinder: **Bangert, Herwig, Dr., Dipl.-Ing.**
**Rudolf Waizenkorngasse 45**
**A-1235 Wien(AT)**

(74) Vertreter: **Hübscher, Helmut, Dipl.-Ing. et al**
**Patentanwälte Dipl.-Ing. Gerhard Hübscher Dipl.-Ing. Helmut Hübscher Dipl.-Ing. Heiner Hübscher Spittelwiese 7**
**A-4020 Linz (AT)**

EP 0 310 590 B1

**Beschreibung**

Die Erfindung bezieht sich auf eine Vorrichtung zur Behandlung, insbesondere Reinigung, von als Kathode geschalteten Innenflächen von Gegenständen durch Ionenbeschuß aus einer Gasentladung, die zwischen mindestens einer im wesentlichen stabförmigen Anode und der Kathode gezündet und aufrechterhalten ist, die die Anode zumindest teilweise umschließt.

Derartige Vorrichtungen dienen zur Oberflächenbehandlung von Materialien, insbesondere in einer Vakuumanlage, z. B. vor einem Beschichtungsprozeß, um die Flächen zu reinigen und eine bessere Haftung der aufzubringenden Schichten zu erzielen. Auch zum Aufrauhen von Oberflächen bzw. zur Freilegung der Korngrenzenstruktur können solche Vorrichtungen eingesetzt werden. Dieses Reinigen bzw. der Ionenbeschuß wird im weiteren Ionenätzen genannt.

Zur Behandlung von Gegenständen, insbesondere zur Obeflächenreinigung, ist es bekannt, plasmachemische Ätzverfahren (reactive ion etching) einzusetzen, d. h. chemisches Ätzen von Substraten mittels in einem Plasma aktivierten Reagenzien (nicht aber durch direkten Ionenbeschuß). Bei diesem Verfahren wird das Oberflächenmaterial der Substrate durch chemische Reaktion in flüchtige Bestandteile zerlegt oder umgewandelt und mit Hilfe von Vakuumpumpen abgesaugt. Das verwendete Reaktionsgas ist von entscheidender Bedeutung.

Aus der DD-A-237 331 ist es bekannt, unter Ausntuzung des Hohl- und Doppelkathodeneffektes durch elektrischen Einschluß der Plasmaelektronen innerhalb der Kathodenanordnung einen hohen Ionisationsgrad und damit eine weitgehende Aktivierung des Reaktionsgases zu erreichen. Der Gegenstand wird als dritte Elektrode eingebracht und es können nur ebene, kleinflächige Substrate behandelt werden. Es ist auch keine Trennung bzw. Unterteilung der zu ätzenden Oberflächen möglich; dies geschieht nötigenfalls mit Hilfe von Photolack.

Aus der US-A-4 521 286 ist ein Ätzverfahren bekannt, bei dem unter Ausnutzung des Hohlkathodeneffektes zwischen ebenen RF-Elektroden ein Gegenstand abgeätzt wird. Diese bekannte Anordnung besitzt keine stabförmige Anode, die Anode ist der Behälter. Es können nur ebene, kleinflächige Substrate behandelt werden.

Aus den JP-A-59-76876, JP-A-58-144476, JP-A-58-67870, JP-A-58-55568 und JP-A-58-39784 sind reaktive Ionenätzverfahren bekannt. Dabei werden ebene Substrate durch z. B. magnetfeldunterstütztes Plasmaätzen oder HF-Ionenätzen behandelt. Die Anoden sind Platten, die parallel zu Kathodenplatten verlaufen.

Zur Durchführung vakuumtechnologischer Prozesse, bei denen die Energie der Ionen auf eine rohrförmige Kathode mit hoher Leistungsdichte und hoher Gleichmäßigkeit übertragen werden, ist es schließlich aus der DD-A-123 952 bekannt, die Gasentladung zwischen einer stabförmigen Anode und der diese Anode koaxial umschließenden rohrförmigen Kathode zu zünden. Eine Trennung bzw. Unterteilung der zu ätzenden Oberflächen ist nicht möglich.

Die beim Ionenätzen der Innenflächen hohler Körper auftretenden Probleme sind in der Praxis keineswegs zufriedenstellend gelöst, insbesondere ist der mit dem bisher eingesetzten Ätzverfahren erzielbare Reinigungseffekt, d. h. die insbesondere gleichmäßige und nahezu rückstandsfreie Abtragung von physiko- und/oder chemosorbierten Oberflächenschichten, im allgemeinen unzureichend.

Der Erfindung liegt somit die Aufgabe zugrunde, eine gleichmäßige und nahezu rückstandfreie Abtragung von physiko- und/oder chemosorbierten Oberflächenschichten zu ermöglichen.

Die Erfindung löst diese Aufgabe dadurch, daß zur Vergrößerung der Auffangfläche für die abgesputterten Teilchen bzw. Verunreinigungen und zur Trennung bzw. Unterteilung der zu behandelnden Innenflächen die im wesentlichen stabförmige Anode mit zumindest einem, vorzugsweise Anodenpotential besitzenden, Flügel versehen ist.

Durch die Vergrößerung der für die Ablagerung der abgesputterten Teilchen zur Verfügung stehenden Fläche werden verunreinigungsfreie Innenflächen erreicht, die später einwandfrei beschichtet werden können. Es erfolgt eine intensive Abarbeitung der jeweiligen Fläche bzw. eine gute Abtragung der Oberflächenverunreinigungen, wobei zugleich vermieden wird, daß sich die durch den Ionenbeschuß abgetrennten Teilchen an einer anderen Stelle (z. B. im Randbereich der Gasentladung) wieder auf die bearbeitende Fläche niederschlagen. Je nach Wunsch können Flächen vom Ionenbeschuß ausgenommen werden. Aufgrund der Anordnung von relativ zur abzuätzenden Fläche großflächigen Flügeln und der begrenzten Gasentladung ergibt sich eine intensive Abarbeitung der Flächen und eine optimale Ablagerung der abgetragenen Teilchen auf den Flügeln.

Eine bevorzugte Ausführungsform der erfindungsgemäßen Vorrichtung ist dadurch gekennzeichnet, daß eine Antriebseinheit vorgesehen ist, mit der die Anode mit dem(n) Flügel(n) und/oder ein die Innenfläche tragender Körper um die (Längs)Achse der Anode relativ gegeneinander rotierbar bzw. verschwenkbar ist/sind. Damit kann eine gleichmäßige Oberflächenbehandlung der Innenflächen durchgeführt bzw. das Ausmaß der Behandlung an verschiedene Innenflächenbereiche angepaßt werden.

Eine weitere bevorzugte Ausführungsform der erfindungsgemäßen Vorrichtung ist dadurch gekennzeichnet, daß die Anode, um bestimmte Innenflächenbereiche, z.B. Spann- bzw. Halteleisten, Trenn- bzw. Distanzstege, oder Bereiche mit Meßinstrumenten usw., keinem Ionenbeschuß auszusetzen, eine der Anzahl der nicht zu behandelnden Flächen bzw. der Stege entsprechende Anzahl von insbesondere Anodenpotential besitzenden Flügeln trägt, die von der Anode in Richtung auf die nicht dem Ionenbeschuß auszusetzenden Flächen abgehen und deren Ende jeweils in einem Abstand vor diesen endet, der kleiner als der für die Zündung einer Gasentladung zwischen den Enden der Flügel und der nicht zu behandelnden Flächen notwendige Abstand sein soll.

Bevorzugt ist es ferner, wenn sämtliche Kathodenaußenflächen bzw. die Außenflächen des Gegenstandes, z.B. eines Trägers für Gegenstände, durch insbesondere ortsfeste auf Masse- oder Anodenpotential befindliche Flächen geschirmt sind. Damit werden die Zündung von nicht erwünschten Gasentladungen vermieden und somit die Ablagerung von abgesputterten Teilchen an den zu behandelnden Innenflächen verhindert.

Mit der erfindungsgemäßen Vorrichtung wird erreicht, daß ein Reinigungseffekt ausschließlich und gleichmäßig an den gewünschten Flächenbereichen stattfindet, während nicht zu bearbeitende Flächen durch Entladungsdunkelräume bzw. mittels Schirmflächen vom Ionenbeschuß ausgenommen werden können. Erfindungsgemäß wird eine unerwünschte Umlagerung von abgesputtertem Material von nicht zu reinigenden Oberflächen oder von einer nur teilweise dem Ionenbeschuß ausgesetzten Fläche auf die zu reinigende Fläche vermieden. Die Beschränkung des Plasmas der Gasentladung auf den Reinigungsbereich ist auch insofern von Bedeutung, als damit alle weiteren unkontrollierten Abstäubungsvorgänge, z.B. an der Rezipientenoberfläche, welche die gesamte Anordnung einschließt, vermieden werden. Ein ständiger Durchstrom des Sputtergases, z.B. Argon, verhindert die Konzentration der Verunreinigung im Gasentladungsraum, womit die Reinigungswirkung erhöht werden kann. Die Flügel sind vorteilhafterweise plattenförmig und erstrecken sich über die Länge der Anode.

Das Ionenätzen kann mit einer RF- oder DC-Gasentladung durchgeführt werden. Es können Flächen beliebiger Materialien z.B. Glas, Keramik, Kunststoff, Metall usw. abgeätzt werden.

Die erfindungsgemäße Vorrichtung ist auch zum reaktiven Ätzen geeignet.

Weitere vorteilhafte Ausführungsformen der Erfindung sind der nachfolgenden Beschreibung, den Zeichnungen und den Patentansprüchen zu entnehmen.

Vorteilhaft wird die Erfindung zur Behandlung von Lagerschalen bzw. Buchsen eingesetzt, weshalb sie anhand von Lagerschalen beispielsweise näher erläutert wird, ohne deshalb darauf eingeschränkt zu sein. Z.B. ist es auch möglich, Zylinderlaufflächen, Kugellagerringe, Rohre vor der Korrosionsschutzbeschichtung, Wälzlagerlaufflächen und andere Bauteile zu behandeln. Bevorzugt ist es, wenn die zu behandelnden Flächen von den Innenflächen einer Anzahl von in Reihe(n) angeordneten Lagerschalen oder -büchsen gebildet sind. Es ist möglich, daß die zu behandelnden Flächen zumindest teilweise konkav gekrümmt sind, gegebenenfalls von der Innenfläche eines hohlen Körpers, z.B. Zylinders, bzw. eines konkaven Flächengebildes oder von zu einem hohlen Körper bzw. konkaven Flächengebilde zusammengesetzten Flächen gebildet sind, oder ebene Flächen umfassen, die in einer die Elektrode zumindest teilweise umgebenden Lage angeordnet sind.

Im folgenden wird die Erfindung anhand der Zeichnung beispielsweise näher erläutert. Es zeigen: Fig. 1 schematisch eine Behandlungsvorrichtung bzw. Ionenätzstation, Fig. 2 eine Prinzipdarstellung, Fig. 3 und 4 Ausführungsformen von Anoden mit Flügeln, Fig. 5 und 6 alternative Anodenausführungen, Fig. 7 eine Detailansicht eines Trennsteges und Fig. 8 und 9 weitere Ausführungsformen der Erfindung.

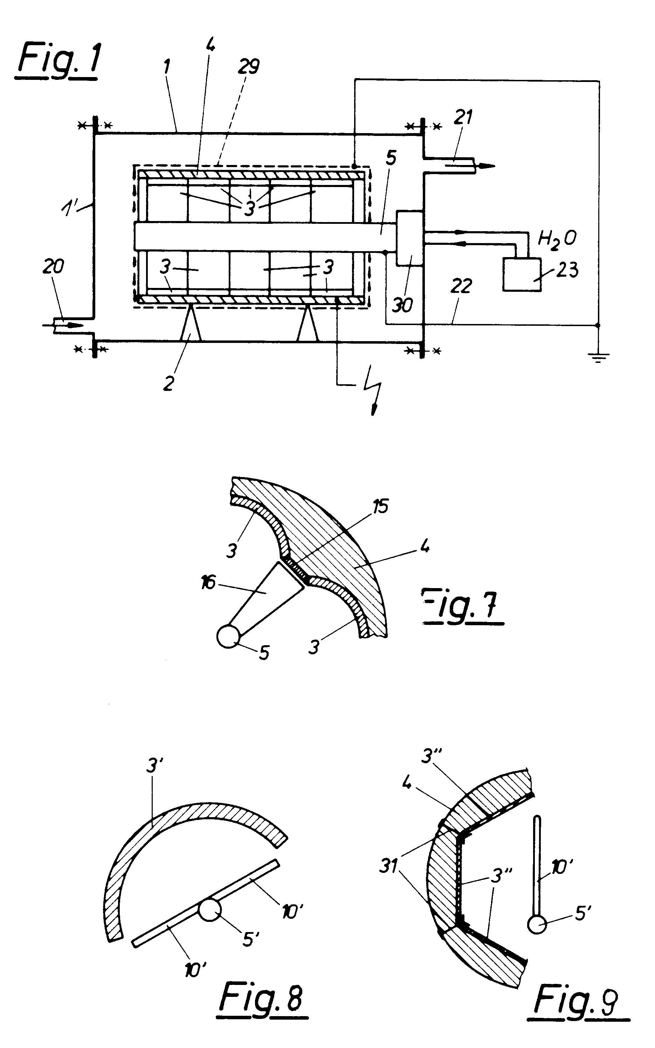

Die vorteilhafterweise in einer Reihe zu einem Zylinder aneinandergefügten Ringe bzw. Ringsegmente, insbesondere Lagerschalen 3 werden in einen Träger 4 eingesetzt, der in eine Behandlungsvorrichtung einbringbar ist. Eine derartige Ionenätzanordnung umfaßt gemäß Fig. 1 einen gasdichten Rezipienten 1 mit einem durch Schrauben befestigbaren Deckel 1′. In der Arbeitsstellung des Trägers 4 umschließen die Lagerschalen 3 die Anode 5. Nach Beendigung des Arbeitsvorganges wird der Träger 4 dem Rezipienten 1 entnommen und die Gegenstände werden weiterbearbeitet.

Mit 20 ist eine Gaszufuhrleitung und mit 21 ist eine Leitung zu einer Vakuumpumpe bezeichnet. Der Anschluß (Erdanschluß) für die Ätzanode 5 ist mit 22, ihre Kühlmittelzufuhreinrichtung mit 23 bezeichnet. Vor dem Ätzen wird der Rezipient 1 auf etwa $10^{-5}$ mbar evakuiert. Das Ätzen erfolgt sodann bei einem Gasdruck von mehr als $10^{-3}$ mbar, Der Träger 4 ruht auf gegenüber dem Rezipient 1 isolierten Standfüßen 2 od.dgl. und ist allseitig von einem geerdeten Schirm 29 umgeben. Mit einer Antriebseinrichtung 30, z.B. einem Motor, kann die Anode 5 bewegt bzw. verstellt werden.

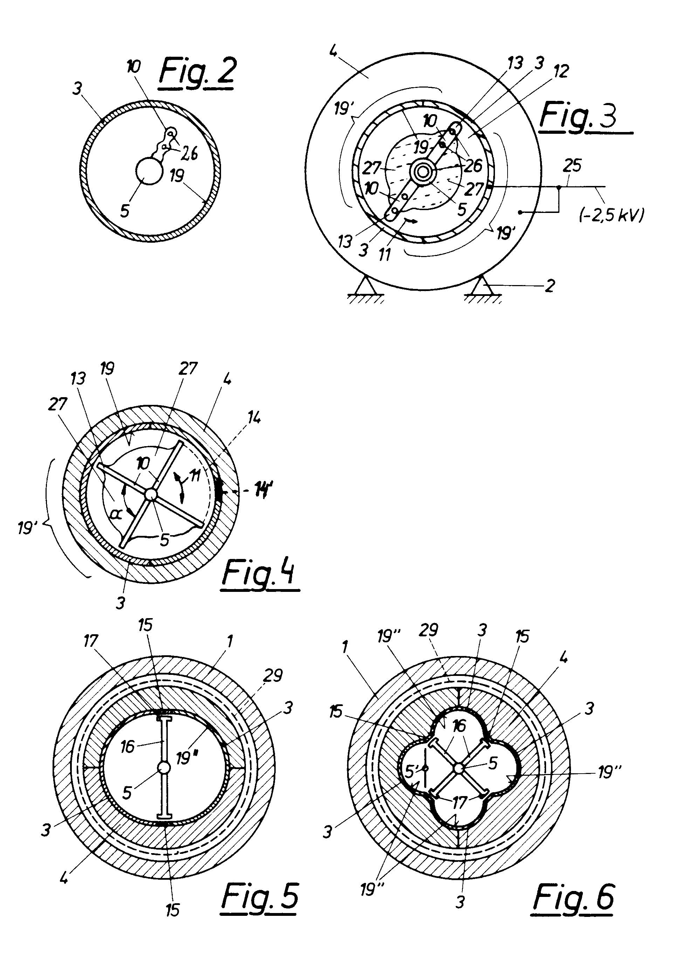

Fig. 2 zeigt eine erfindungsgemäße Anordnung im Prinzip anhand eines Querschnitts. Die Anode 5, die einen Flügel 10 mit Kühlkanälen 26 trägt, der zur Vergrößerung der Anodenfläche zum verbesserten Auffangen der durch das Ätzen freigesetzten Verunreinigungen dient. Die Gasentladung kann mit der gesamten Fläche 19 gezündet werden. Zur Vergleichmäßigung der Entladung kann die Anode rotiert werden. Die Form des Flügels ist im wesentlichen frei wählbar; die Kühlkanäle 26 sind bei hoher Leistung der Anode zweckmäßig.

Fig. 3 zeigt einen Schnitt durch einen Träger 4 entsprechend Fig. 1, z.B. eine Röhre. Innerhalb des Trägers 4 ist eine Reihe von Lagerschalen 3 nebeneinander angeordnet. Die halbkreisförmigen Lagerschalen 3 sind zu einem vollen Kreis bzw. zu einer Zylinderfläche zusammengeschlossen und als Kathode an ein gegenüber der Anode 5 negatives Potential angeschlossen; in den Innenraum 12 der Lagerschalen 3 ragt die Ätzanode 5. Die Lagerschalen 3 und der Träger 4 liegen auf einem Potential von z.B. -2,5 kV.

Die Anode 5 ist entweder geerdet oder befindet sich auf einem gegenüber dem Potential der Lagerschalen 3 positiven Potential. Im Inneren besitzen die Anode 5 und/oder die Flügel 10 zumindest einen Kühlkanal 26 zur Durchleitung von Kühlwasser. Die Anode 5 trägt zwei Flügel 10, welche diametral angeordnet sind und sich mit der Anode z.B. in Richtung des Pfeiles 11 im Innenraum 12 der Lagerschalen 3 drehen oder schwenken. Die Enden 13 der Flügel 10 reichen so nahe an die Innenfläche 19 der Lagerschalen 3, daß zwischen den Lagerschalen 3 und den Enden 13 der Flügel 10 keine Gasentladung zünden kann. Nur zwischen den weiter innen liegenden Bereichen der Flügel 10 bzw. der Anode 5 und den gegenüberliegenden Flächenbereichen der Lagerschalen 3 bildet sich die Gasentladung aus (Bereich 27). Diese Anordnung hat zur Folge, daß im Innenraum 12 zwei getrennte Gasentladungsbereiche 27 gezündet und aufrechterhalten werden, die sich jeweils über weniger als den halben Umfang der Innenfläche 19 bzw. über Teilbereiche 19′ der Lagerschalen 3 erstrecken. Die Gasentladungen überstreichen jedoch bei Rotation der Anode 5 kontinuierlich die gesamte Innenfläche 19 der Lagerschalen 3. Diese Anordnung hat den Vorteil, daß die von dem Lagermaterial im Bereich 19′ abgesputterten Teilchen ausschließlich auf den Flügeln 10 bzw. der Anode 5 abgelagert werden und sich nicht wieder in Bereichen ablagern, die bereits gereinigt sind. Wäre lediglich eine Anode 5 im Innenraum 12 ohne Flügel 10 angeordnet, so würden die von der Innenfläche der Lagerschalen 3 abgesputterten Teilchen nur zum Teil auf der Anode 5 abgelagert, der andere Teil würde sich wieder an anderen Stellen der zu reinigenden Innenfläche niederschlagen.

Fig. 4 zeigt eine Anordnung, bei der die Anode 5 vier kreuzweise angeordnete Flügel 10 trägt, wobei zwei der Flügel 10 durch eine Schirmfläche 14 verbunden sind. Damit sind drei Ätzbereiche gegeben, die bei Rotation der Anode 5 die Oberfläche der Lagerschalen 3 überstreichen. Bevorzugt wird eine derartige Anordnung eingesetzt, wenn z.B. ein Bereich 14′ der Innenfläche nicht bearbeitet werden soll; in diesem Fall wird die Anode gemäß Pfeil 11 gependelt derart, daß die den Bereich 14′ einschließenden Flügel nur bis zum Bereich 14′ verschwenkt werden bzw. die Schirmfläche 14 diesen Bereich 14′ nicht zur Zündung einer Gasentladung freilegt.

Der Abstand zwischen der Schirmfläche 14 und der Innenfläche der Lagerschale 3 ist so gering gehalten, daß er kleiner ist als die für ionisierende Stöße erforderliche Wegstrecke der Elektronen (Dunkelraum); diese freie Weglänge hängt insbesondere von den Parametern, Druck, Temperatur, Gasart usw. ab.

Die Schwenk- oder Drehbewegung der Anode 5 relativ zu den zu behandelnden Flächen 19 erfolgt mit der Antriebseinrichtung 30.

Die Anzahl der Flügel, ihre Winkellage und die Umdrehungsgeschwindigkeit sind wählbar. Die Wahl des Winkels zwischen den Flügeln 10 hängt von der gewünschten Intensität der Abätzung bzw. der Größe der zu behandelnden Flächen 19 ab; es ist z.B. auch möglich, nur eine halbzylindrische Fläche zu ätzen.

Fig. 5 zeigt eine Anordnung, bei der im Rezipienten 1 ein aus zwei Hälften bestehender Träger 4 vorgesehen ist, in dem eine Anzahl von Reihen von Lagerschalen 3, im vorliegenden Fall zwei Reihen, derart angeordnet sind, daß ihre Endbereiche durch nicht zu behandelnde Flächen bzw. durch Stege 15 getrennt sind. Die Stege 15 können aus beliebigen Materialien gefertigt sein oder aus dem Träger 4 ausgebildet sein und haben die Aufgabe, die Lagerschalen 3 am Träger 4 zu spannen und voneinander beabstandet zu halten. Um zwischen der Anode 5 und den einzelnen Reihen von Lagerschalen 3 jeweils getrennte Gasentladungen aufbauen zu können, ist die Anode 5 mit Flügeln 16 versehen, die in Richtung auf die Stege 15 abgehen. In den Endbereichen der Flügel 16 sind querverlaufende Abschirmflächen 17 vorgesehen, welche den Stegen 15 in einem Abstand gegenüberliegen, der kleiner ist, als er zur Zündung einer Gasentladung notwendig wäre. Auf diese Weise wird die Gasentladung bei feststehendem Flügel von den Stegen 15 ferngehalten und ein Absputtern des Stegmaterials und eine Ablagerung desselben auf den Lagerflächen 19″ vermieden. Zweckmäßig ist es, wenn die Länge der Abschirmflächen 17 derart gewählt wird, daß die Gasentladung gerade im Endbereich der Lagerschalen 3 einsetzt, um diese bereits optimal ätzen zu können. Gleichzeitig erfolgt aufgrund der vergrößerten Anodenfläche eine optimale Ablagerung der abgesputterten Teilchen auf der Anode bzw. den Flügeln 16.

Fig. 6 zeigt eine Anordnung, bei der in dem Träger 4 eine Anzahl von Reihen, im vorliegenden Fall vier Reihen von Lagerschalen 3, angeordnet sind, die jeweils durch Stege 15 voneinander getrennt sind. In diesem Fall weist die Anode 5 vier Flügel 16 auf, die zu den Stegen 15 abgehen und in ihren Endbereichen die Abschirmflächen 17 tragen. Diese Anordnung ist insbesondere dann von Vorteil, wenn der Durchmesser der Lagerschalen 3 gering ist und man die Anode 5, deren Durchmesser etwa 20 - 50 mm beträgt, nicht in die Lagerschalen 3 einführen kann. Im Fall der Ausführungsform der Fig. 5 und 6 wird die Anode 5 sinnvollerweise nicht rotiert, sondern bleibt lagefest. Vorteilhaft ist es, wenn der Abstand zwischen der im wesentlichen zylindrischen Anode 5 und der Innenfläche (Kathode) zumindest 25 mm beträgt.

Die Anzahl der durch Stege 15 getrennten Lagerschalen 3 kann beliebig sein, es können z.B. drei, vier, fünf, sechs oder mehr Reihen von Lagerschalen 3 innerhalb eines Trägers 4 angeordnet werden. Die Anode 5 trägt dabei jeweils eine der Anzahl der Stege 15 entsprechende Anzahl von Flügeln 16, um die einzelnen Lagerschalen 3 getrennt abätzen zu können.

Die in Fig. 1 dargestellte Anode 5 kann eine Anode sein, wie sie in den Fig. 2 bis 4 drehbar mit Flügeln 10 dargestellt ist, oder kann eine feststehende Anode mit Flügeln 16 sein. Der Schirm 29 umgibt den Träger 4 über seine Mantel- und Stirnflächen und ist auch in den Fig. 5 und 6 angedeutet; der Schirm 29 kann vom Träger 4 oder vom Rezipienten 1 getragen werden. Die Anoden können zylindrisch oder im Querschnitt polygonal ausgebildet sein. Das Material für die Anoden und die Flügel kann z.B. Al, Stahl od.dgl. sein. Die Flügel können einstückig mit der Anode sein, oder sie sind an dieser befestigt, z.B. angeschraubt. Bevorzugterweise stehen die abzuätzenden Schalen bzw. Körper fest und die Anode mit den Flügeln wird bei den Ausführungsformen gemäß Fig. 2, 3 und 4 mit der in Fig. 1 angedeuteten Antriebseinheit 30 rotiert bzw. verschwenkt. Wenn die Behandlung der Zwischenflächen bzw. Stege 15 nicht unterbleiben muß, können auch die Anoden gemäß der Fig. 5 und/oder 6 bewegt bzw. rotiert werden.

Fig. 7 zeigt eine Anordnung, bei der die Stege 15 die Lagerschalen 3 im Träger 4 festhalten. Die Stege 15 sind am Träger 4 befestigbar und halten die Lager 3 an ihren Enden fest. Fig. 7 zeigt auch eine andere Form der Flügel 16. Vorteilhaft ist es, wenn die einander gegenüberliegenden Flächen der Flügel 16 und der Stege 15 aneinander angepaßte Form besitzen, daß der Abstand immer unterhalb des zur Zündung einer Gasentladung nötigen Abstandes bleibt.

Fig. 8 zeigt eine Möglichkeit, Hohlkörper 3′ bzw. konkave Flächen abzuätzen, indem eine Anode 5′ mit Flügeln 10′ vor der Öffnung der Fläche angeordnet wird. Es ist möglich, vier Anoden 5′ mit ihren Flügeln 10′ bei der Anordnung gemäß Fig. 6 anstelle der dort dargestellten Anode 5 und den Flügeln 16 einzusetzen, wie bei der linksgelegenen Lagerschale 3 angedeutet.

Fig. 9 zeigt schematisch eine Anordnung ähnlich Fig. 7, bei der der abzuätzende Hohlkörper aus einer Anzahl getrennt angeordneter, eine Innenfläche ausbildender Teile 3″ zusammengesetzt ist. Diese Teile werden von Haltern 31 am Träger 4 gehalten.

Vorteilhaft dient die erfindungsgemäße Vorrichtung zum Bearbeiten von ebenen und/oder zumindest teilweise gekrümmten Flächen, die derart angeordnet sind, daß sie zumindest teilweise die Anode umgeben. Dazu können die Flächen in Form von Hohlkörpern bzw. Teilhohlkörpern angeordnet werden, deren Innenflächen abgesputtert werden.

Es wurde gefunden, daß es zweckmäßig ist, den Abstand (in cm) zwischen den Flügeln bzw. den Schirmflächen 14 bzw. Abschirmflächen 17 und den Innenflächen oder zwischen der Kathodenaußenfläche und dem Schirm 29 kleiner als

$$\frac{6.10^{-3}}{p}$$

zu halten, wobei p in mbar angegeben wird. Wird diese Anforderung eingehalten, treten keine Gasentladungen zwischen den genannten Bauteilen auf.

Auch in den Flügeln 16 bzw. Abschirmflächen 17 können Kühlkanäle 26 ausgebildet sein.

**Patentansprüche**

1. Vorrichtung zur Behandlung, insbesondere Reinigung, von als Kathode geschalteten Innenflächen von Gegenständen durch Ionenbeschuß aus einer Gasentladung, die zwischen mindestens einer im wesentlichen stabformigen Anode und der Kathode gezündet und aufrechterhalten ist, die die Anode zumindest teilweise umschliest, dadurch gekennzeichnet, daß zur Vergrößerung der Auffangfläche für die abgesputterten Teilchen bzw. Verunreinigungen und zur Trennung bzw. Unterteilung der zu behandelnden Innenflächen die im wesentlichen stabförmige Anode mit zumindest einem, vorzugsweise Anodenpotential besitzenden, Flügel (10,16) versehen ist (Fig. 2, 5).

2. Vorrichtung nach Anspruch 1, dadurch gekennzeichnet, daß eine Antriebseinheit (30) vorgesehen ist, mit der die Anode (5) mit dem(n) Flügel(n) (10) und/oder ein die Innenfläche (19) tragender Körper (3) um die (Längs)Achse der Anode relativ gegeneinander rotierbar bzw. verschwenkbar ist/sind (Fig. 2,3).

3. Vorrichtung nach Anspruch 1 oder 2, dadurch gekennzeichnet, daß zwischen zwei benachbarten Flügeln (10) eine insbesondere Anodenpotential besitzende Schirmfläche (14) vorgesehen ist, die vorzugsweise von diesen Flügeln (10) getragen und die in einem Abstand vor der zu reinigenden Fläche (19) angeordnet bzw. vorbeibewegbar ist.

4. Vorrichtung nach einem der Ansprüche 1 bis 3, dadurch gekennzeichnet, daß die Längsachse der Anode (5) im Krümmungsmittelpunkt bzw. Symmetriezentrum des Hohlkörpers bzw. der vorzugsweise von einer Zylinderfläche gebildeten Innenfläche (19) angeordnet ist.

5. Vorrichtung nach einem der Ansprüche 1 bis 4, dadurch gekennzeichnet, daß die Anode (5) eine der Anzahl der nicht zu behandelnden Flächen bzw. der Stege (15) entsprechende Anzahl von insbesondere Anodenpotential besitzenden Flügeln (16) trägt, die von der Anode (5) in Richtung auf die nicht dem Ionenbeschuß auszusetzenden Flächen abgehen und deren Ende jeweils in einem Abstand vor diesen endet.

6. Vorrichtung nach einem der Ansprüche 1 bis 5, dadurch gekennzeichnet, daß die Flügel (16) in ihren Endbereichen querverlaufende Abschirmflächen (17) tragen, deren Breite kleiner oder gleich der Breite der nicht zu reinigenden Flächen ist.

7. Vorrichtung nach einem der Ansprüche 1 bis 6, dadurch gekennzeichnet, daß die Anode (5) mit den Flügeln (10,16), die Abschirmflächen (17), die zu behandelnden Flächen (19' ,19") und die nicht zu behandelnden Flächen (15) sektorenweise ident oder zentrisch symmetrisch angeordnet sind bzw. daß die Anode (5) in der Schnittachse der Symmetrieebene der aus den abzuätzenden Flächen (19") gebildeten Anordnung angeordnet ist.

8. Vorrichtung nach einem der Ansprüche 1 bis 7, dadurch gekennzeichnet, daß zwei diametrale oder mehrere gegebenenfalls ungleiche Winkel ($\alpha$) einschließende Flügel (10,16) vorgesehen sind.

9. Vorrichtung nach einem der Ansprüche 1 bis 8, dadurch gekennzeichnet, daß die Anode (5) mit den Flügeln (10,16) sternförmig aufgebaut ist.

10. Vorrichtung nach einem der Ansprüche 1 bis 9, dadurch gekennzeichnet, daß nebeneinander auf der Anode (5) angeordnete Flügel (10,16) und die zu behandelnden Flächen (19',19") eine im wesentlichen für das Plasma bzw. für die Glimmentladung geschlossene Kammer bilden.

11. Vorrichtung nach einem der Ansprüche 1 bis 10, dadurch gekennzeichnet, daß der (die) Flügel (10,16) nahe bis zu den Innenflächen reicht(en), z.B. im Abstand von weniger als 30 mm, vorzugsweise weniger als 20 mm, insbesondere weniger als 10 mm davor endet(n).

12. Vorrichtung nach einem der Ansprüche 1 bis 11, dadurch gekennzeichnet, daß die Anode und/oder die Flügel (10,16) von Kühlkanälen (26) durchsetzt bzw. an eine Kühleinrichtung (23) angeschlossen ist/sind.

13. Vorrichtung nach einem der Ansprüche 1 bis 12, dadurch gekennzeichnet, daß sämtliche Kathodenaußenflächen bzw. die Außenflächen des Gegenstandes, z.B. eines Trägers (4) für Gegenstände, durch insbesondere ortsfeste, auf Masse- oder Anodenpotential befindliche Flächen (29) geschirmt sind.

14. Vorrichtung nach einem der Ansprüche 1 bis 13, dadurch gekennzeichnet, daß die Form der Endflächen der Flügel (16) bzw. die Form der Abschirmflächen (17) an die Form der nicht zu behandelnden Innenflächen angepaßt ist bzw. dieser entspricht.

15. Verfahren zum Betreiben einer Vorrichtung nach den Ansprüchen 3, 5 und 11, dadurch gekennzeichnet, daß die Betriebsparameter insbesondere hinsichtlich des Druckes, der Temperatur und der Gasart so gewählt werden, daß der Abstand der Schirmfläche (14) und/oder der Enden (13) der Flügel (10, 16) von der zu reinigenden Fläche (19) oder von den nicht dem Ionenbeschuß auszusetzenden Flächen kleiner als die freie Weglänge der abgesputterten Atome im Restgas bzw. kleiner als der zur Ausbildung einer Glimmentladung notwendige Abstand ist.

16. Verfahren nach Anspruch 15, dadurch gekennzeichnet, daß der Abstand (in cm) zwischen den Enden der Flügel (10, 16) bzw. den Schirmflächen (14) bzw. den Abschirmflächen (17) und der Innenfläche kleiner als

$$\frac{6.10^{-3}}{p}$$

ist, wobei p der Behandlungsdruck gemessen in mbar ist.

## Claims

1. A device whereby the inner surfaces of objects connected as a cathode are processed, more particularly cleaned, by ion bombardment from a gas discharge which is ignited end maintained between at least one substantially rod-like anode and the cathode, which at least partly surrounds the anode, characterised in that in order to increase the surface for trapping the sputtered particles or impurities and in order to separate or divide the inner surfaces for processing, the substantially rod-shaped anode has at least one fin (10, 16), preferably at anode potential (Figs. 2, 5).

2. A device according to claim 1, characterised in that a drive unit (30) is provided by means of which the anode (5), the fins (10) and/or a body (3) bearing the inner surface (19) are rotatable or pivotable relatively to one another around the (longitudinal) axis of the anode (Figs. 2, 3).

3. A device according to claim 1 or 2, characterised in that a screen surface (14), more particularly at anode potential, is provided between two adjacent fins (10) and is preferably carried by the fins (10) and is movable past or disposed at a distance in front of the surface (19) for cleaning.

4. A device according to any of claims 1 to 3, characterised in that the longitudinal axis of the anode (5) is disposed at the centre of curvature or the centre of symmetry of the hollow body or the inner surface (19), which is preferably a cylindrical surface.

5. A device according to any of claims 1 to 4, characterised in that the anode (5) has a number of fins (16), more particularly at anode potential, equal to the number of surfaces or webs (5) not to be processed, the fins extending from the anode (5) towards the surfaces not to be exposed to ion bombardment and the ends of the fins each ending at a distance in front of the respective surfaces.

6. A device according to any of claims 1 to 5, characterised in that the fins (16), at their end regions, have transverse screening surfaces (17) having a width less than or equal to the width of the surfaces which are not to be cleaned.

7. A device according to any of claims 1 to 6, characterised in that the anode (5), the fins (10, 16), the screening surfaces (17), the surfaces (19', 19") to be processed and the surfaces (15) not to be processed are disposed in sectors in identical manner or with central symmetry, or the anode (5) is disposed along the axis intersecting the plane of symmetry of the arrangement formed by the surfaces (19") to be etched.

8. A device according to any of claims 1 to 7, characterised in that two diametral fins or a number of fins (10, 16), optionally including unequal angles ($\alpha$) are provided.

9. A device according to any of claims 1 to 8, characterised in that the anode (5) end the fins (10, 16) have a star-shaped construction.

10. A device according to any of claims 1 to 9, characterised in that fins (10, 16) disposed side by side on the anode (5) co-operate with the surfaces (19', 19") for processing to form a substantially sealed chamber for the plasma or for the glow discharge.

11. A device according to any of claims 1 to 10, characterised in that the fin or fins (10, 16) extend to near the inner surfaces, e.g. end at a distance of less than 30 mm, preferably less than 20 mm, more particularly less then 10 mm in front of them.

12. A device according to any of claims 1 to 11, characterised in that cooling ducts (26) extend through the anode and/or the fins (10, 16) or are connected to a cooling device (23).

13. A device according to any of claims 1 to 12, characterised in that all the outer surfaces of the cathode or the outer surfaces of the object, e.g. a carrier (4) for objects, are screened, more particularly by stationary surfaces (29) at earth or anode potential.

14. A device according to any of claims 1 to 13, characterised in that the shape of the end surfaces of the fins (16) or the shape of the screening surfaces (17) is adapted to or matches the shape of the inner surfaces which are not to be processed.

**15.** A method of operating a device according to claims 3, 5 and 11, characterised in that the operating paramaters, more particularly with regard to the pressure, temperature and nature of the gas, are chosen so that the distance of the screen surface (14) and/or the ends (13) of the fins (10, 16) from the surface (19) to be cleaned or from the surfaces not to be exposed to ion bombardment, is less than the free path length of the sputtered atoms in the residual gas or is less than the distance necessary for producing a glow discharge.

**16.** A method according to claim 15, characterised in that the distance (in cm) between the inner surface and the ends of the fins (10, 16) or the screen surfaces (14) or the screening surfaces (17) is less than

$$\frac{6 . 10^{-3}}{p}$$

where p is the processing pressure measured in mbar.

**Revendications**

**1.** Dispositif pour traiter, notamment nettoyer, des surfaces intérieures d'objets, connectées en cathode, par projection d'ions par une décharge dans un gaz qui est amorcée entre au moins une anode sensiblement en forme de barre et la cathode, qui entoure au moins partiellement l'anode,
caractérisé en ce que, pour agrandir la surface collectrice des particules ou impuretés projetées et pour séparer ou subdiviser les surfaces intérieures à traiter, l'anode sensiblement en forme de barre est munie d'au moins une ailette (10, 16) possédant de préférence le potentiel de l'anode (figures 2, 5).

**2.** Dispositif selon la revendication 1,
caractérisé en ce qu'il est prévu une unité d'entraînement (30) sous l'action de laquelle l'anode (5), munie de l'ailette ou des ailettes (10) et/ou un corps (3) qui porte la surface intérieure (19), peut ou peuvent tourner ou osciller l'un par rapport à l'autre, autour de l'axe (longitudinal) de l'anode (figures 2 et 3).

**3.** Dispositif selon la revendication 1 ou 2,
caractérisé en ce qu'il est prévu, entre deux ailettes (10) adjacentes, une surface d'écran (14) qui possède en particulier le potentiel de l'anode, qui est portée de préférence par ces ailettes (10) et qui est disposée et peut circuler à une certaine distance devant la surface à nettoyer (19).

**4.** Dispositif selon une des revendications 1 à 3, caractérisé en ce que l'axe longitudinal de l'anode (5) est disposé au centre de courbure ou au centre de symétrie du corps creux ou de la surface intérieure (19) qui est de préférence formée d'une surface cylindrique.

**5.** Dispositif selon une des revendications 1 à 4, caractérisé en ce que l'anode porte un nombre d'ailettes (16), possédant en particulier le potentiel de l'anode, qui correspond au nombre des surfaces ou intervalles (15) qui ne sont pas à traiter, qui partent de l'anode (5) en direction des surfaces qui ne doivent pas être exposées à la projection d'ions, et dont l'extrémité se termine à une certaine distance avant d'atteindre ces surfaces.

**6.** Dispositif selon une des revendications 1 à 5, caractérisé en ce que les ailettes (16) portent, dans leurs régions terminales, des surfaces de protection (17), qui s'étendent transversalement, dont la largeur est inférieure ou égale à la largeur des surfaces qui ne sont pas à nettoyer.

**7.** Dispositif selon une des revendications 1 à 6, caractérisé en ce que l'anode (5) munie des ailettes (10, 16), les surfaces de protection (17), les surfaces (19', 19") à traiter et les surfaces (15) qui ne sont pas à traiter, sont disposées sous la forme de secteurs, dans des dispositions identiques ou centrées et symétriques, ou que l'anode (5) est disposée dans l'axe d'intersection du plan de symétrie du dispositif formé par les surfaces (19") qu'il s'agit de traiter.

**8.** Dispositif selon une des revendications 1 à 7, caractérisé en ce qu'il est prévu deux ailettes (10, 16) diamétrales ou plusieurs ailettes (10, 16) qui forment les angles (23) éventuellement dissemblables.

**9.** Dispositif selon une des revendications 1 à 8, caractérisé en ce que l'anode (5) munie des ailettes (10, 16) est en forme d'étoile.

**10.** Dispositif selon une des revendications 1 à 9, caractérisé en ce que les ailettes (10, 16) disposées l'une à côté de l'autre sur l'anode (5) et les surfaces (19', 19") à traiter forment une chambre sensiblement fermée pour le plasma ou la décharge à lueur.

mbar.

11. Dispositif selon une des revendications 1 à 10, caractérisé en ce que l'ailette ou les ailettes (10, 88 16) se prolonge(nt) presque jusqu'aux surfaces intérieures, par exemple se termine(nt) à une distance de moins de 30 mm, de préférence de moins de 20 mm, en particulier de moins de 10 mm avant d'atteindre ces surfaces.

12. Dispositif selon une des revendications 1 à 11, caractérisé en ce que l'anode et/ou les ailettes (10, 16) sont parcourues par des canaux de refroidissement (26) et/ou raccordées à un dispositif de refroidissement (23).

13. Dispositif selon une des revendications 1 à 12, caractérisé en ce que toutes les surfaces extérieures de la cathode ou les surfaces extérieures de l'objet, qui est par exemple un support (4) portant des objets, sont protégées par des surfaces (29), notamment fixes, qui sont portées au potentiel de la masse ou de l'anode.

14. Dispositif selon une des revendications 1 à 13, caractérisé en ce que la forme des surfaces terminales des ailettes (16) ou la forme des surfaces de protection (17) est adaptée à la forme des surfaces intérieures qui ne sont pas à traiter, ou correspond à cette forme.

15. Procédé de mise en oeuvre d'un dispositif selon les revendications 3, 5 et 11, caractérisé en ce que les paramètres de travail, notamment la pression, la température et le type de gaz sont choisis de manière que la distance de la surface d'écran (14) et/ou des extrémités (13) des ailettes (10, 16) à la surface (19) à nettoyer ou aux surfaces qui ne doivent pas être exposées à la projection d'ions, est inférieure à la longueur de parcours libre des atomes projetés dans le gaz restant, ou inférieure à la distance nécessaire pour la formation d'une décharge à lueur.

16. Procédé selon la revendication 15, caractérisé en ce que la distance (en cm) entre les extrémités des ailettes (10, 16) ou les surfaces écran (14) ou les surfaces de protection (17) et la surface intérieure, est inférieure à

$$\frac{6.10^{-3}}{p},$$

où p est la pression de traitement mesurée en

Fig.1

Fig.7

Fig.8

Fig.9

Fig. 2

Fig. 3

(−2,5 kV)

Fig. 4

Fig. 5

Fig. 6